# EUROPÄISCHE PATENTSCHRIFT

(11) **EP 3 323 156 B1**
(45) Veröffentlichungstag und Bekanntmachung des Hinweises auf die Patenterteilung: **15.05.2019**
(21) Anmeldenummer: 16736853.9
(22) Anmeldetag: 07.07.2016
(51) Int. Cl.: H01L 35/30, H01L 35/34, H01L 35/08

(54) **THERMOELEKTRISCHER WÄRMETAUSCHER**
THERMOELECTRIC HEAT EXCHANGER
ÉCHANGEUR DE CHALEUR THERMOÉLECTRIQUE

(30) Priorität: 15.07.2015 DE 102015213294
(43) Veröffentlichungstag der Anmeldung: 23.05.2018
(73) Patentinhaber: MAHLE International GmbH, 70376 Stuttgart (DE)
(72) Erfinder: GRÜNWALD, Jürgen, 71638 Ludwigsburg (DE); HENEKA, Christian, 76227 Karlsruhe (DE)
(74) Vertreter: BRP Renaud & Partner mbB Rechtsanwälte Patentanwälte Steuerberater
(86) Internationale Anmeldenummer: PCT/EP2016/066136
(87) Internationale Veröffentlichungsnummer: WO 2017/009171

(56) Entgegenhaltungen:
- EP-A2- 2 282 356
- DE-A1- 19 856 771
- JP-A- 2000 286 459
- JP-A- 2011 029 295
- US-A1- 2007 220 902
- US-B1- 6 226 994

## Beschreibung

Die vorliegende Erfindung betrifft einen thermoelektrischen Wärmetauscher zum Temperieren eines Fluids, insbesondere für ein Kraftfahrzeug, mit einem Peltier-Element. Die Erfindung betrifft des Weiteren ein solches Peltier-Element.

Zum Temperieren von Fluiden, insbesondere von Gasen, kommen gewöhnlich Wärmetauscher zum Einsatz. Derartige Wärmetauscher erlauben es hierbei, das Fluid zu erwärmen und/oder zu kühlen. Hierzu können solche Wärmetauscher Temperierelemente aufweisen.

Bekannt ist es, als solche Temperierelemente elektrisch dissipative Heizelemente vorzusehen, die beim Durchfließen eines elektrischen Stroms dissipative Wärme erzeugen. Ein solches Heizelement ist aus der WO 92/06570 A bekannt. Das Heizelement ist hierbei als ein Kaltleiter bzw. ein Positive Temperature Coefficient-Heizelement (PTC-Heizelement) ausgebildet und kommt zum Heizen eines Luftstroms zum Einsatz.

Nachteilig bei solchen dissipativen Heizelementen ist, dass sie insbesondere bei geringen zur Verfügung stehenden elektrischen Ressourcen, kein ausreichendes Heizen erlauben und/oder einen zu hohen Ressourcenverbrauch haben.

Aus dem Stand der Technik ist es auch bekannt, zum Temperieren eines Fluides thermoelektrische Temperierelemente einzusetzen. Der Einsatz eines solchen thermoelektrischen Heizelements in einem Wärmetauscher ist aus der DE 10 2009 058 673 A1 und der EP 2 518 424 A1 bekannt. Hierbei kommt jeweils ein Peltier-Element zum Einsatz, das durch eine entsprechende Schaltung und Anlage einer elektrischen Spannung eine Kaltseite und eine Warmseite aufweist. Eine entsprechende Anordnung des Peltier-Elements erlaubt es, außer dem durch den Temperaturunterschied bedingten Wärmeübertrag zwischen dem Fluid und einem anderen Fluid einen durch das Peltier-Element erzielen Wärmeübertrag zu realisieren, so dass der Gesamtwärmeübertrag vergrößert wird. Solche Peltier-Elemente weisen eine Vielzahl von unterschiedlich dotierten Halbleitern auf, welche miteinander verschaltet sind. Um einen Kurzschluss zwischen den Halbleitern zu vermeiden, werden die Halbleiter beidseitig durch eine elektrisch isolierende Beschichtung und/oder eine elektrisch isolierende Platte elektrisch isoliert. Eine solche elektrische Isolierung stellt dabei regelmäßig eine thermische Barriere dar, die einen thermischen Austausch des Peltier-Elements verschlechtert. Da die elektrischen Isolierungen ferner auf den in Wärmeflussrichtung gegenüberliegenden Seiten des Peltier-Elements angeordnet sind, ist der Wärmeaustausch zwischen dem Peltier-Element und dem zu temperierenden Fluid und/oder dem anderen Fluid oder Gegenstand erschwert.

Solche Peltier-Elemente sind zudem starr ausgebildet. Im Betrieb des Peltier-Elements kommt es zu einem Temperaturunterschied innerhalb des Peltier-Elements, der zu thermischen Spannungen innerhalb des Peltier-Elements führt. Diese thermischen Spannungen können dabei zu einer Beschädigung der elektrischen Isolierung des Peltier-Elements und/oder der elektrischen Verbindungen zwischen den Halbleitern und/oder Kurzschlüssen führen, welche die Funktion des Peltier-Elements negativ beeinträchtigen, insbesondere zum Ausfall des Peltier-Elements führen, können.

EP 2 282 356 A2 zeigt einen thermoelektrischen Wärmetauscher mit zwei fluidisch voneinander getrennten Strömungsräumen, zwischen denen ein Peltierelement angeordnet ist, wobei das Peltierelement Verbindungselemente aufweist, welche Halbleiter des Peltierelements elektrisch miteinander kontaktieren.

US 2007/220902 A1 zeigt einen Wärmetauscher mit einem Peltierelement wobei das Peltierelement einen ersten Träger zum Tragen von Halbleitern des Peltierelements aufweist. Das Peltierelement weist zudem einen zweiten Träger und einen dritter Träger auf, wobei in diesen Trägern Wärmeaustauschelemente gehalten sind, welche jeweils über Elektroden elektrisch mit den Halbleitern kontaktiert sind.

Die vorliegende Erfindung beschäftigt sich daher mit dem Problem, für einen ein Peltier-Element aufweisenden thermoelektrischen Wärmetauscher zum Temperieren eines Fluides sowie für ein solches Peltier-Element eine verbesserte oder zumindest andere Ausführungsform anzugeben, die sich insbesondere durch eine verbesserte Effizienz und/oder Beständigkeit auszeichnet.

Dieses Problem wird erfindungsgemäß durch die Gegenstände der unabhängigen Ansprüche gelöst. Vorteilhafte Ausführungsformen sind Gegenstand der abhängigen Ansprüche.

Die vorliegende Erfindung beruht auf dem allgemeinen Gedanken, bei einem thermoelektrischen Wärmetauscher ein Peltier-Element zum Wärmeaustausch zwischen einem durch einen Strömungsraum strömenden Fluid und einem Transferraum einzusetzen und Leiter zum elektrischen Verbinden von Halbleitern des Peltier-Elements in zumindest einem der Räume, das heißt im Strömungsraum und/oder im Transferraum, anzuordnen. Somit ist der im Strömungsraum angeordnete Leiter insbesondere dem strömenden Fluid direkt ausgesetzt bzw. der im Transferraum angeordnete Leiter am Wärmeaustausch mit dem mit dem Transferraum insbesondere unmittelbar beteiligt. Durch die Anordnung der Leiter im Strömungsraum bzw. im Transferraum kommt es zu einem verbesserten Wärmeaustausch zwischen dem Peltier-Element und dem Fluid bzw. zwischen dem Peltier-Element und dem Transferraum. In der Folge kommt es zu einer verbesserten Effizienz des Wärmetauschers. Zudem führt das Anordnen der Leiter im Strömungsraum bzw. im Transferraum zu einer verbesserten Beweglichkeit des Peltier-Elements, so dass insbesondere thermische Spannungen besser abgebaut werden können und es somit zu einer verbesserten Beständigkeit des Wärmetauschers kommt.

Dem Erfindungsgedanken entsprechend weist der Wärmetauscher also den vom zu temperierenden Fluid durchströmbaren Durchströmungsraum sowie den Transferraum auf, der fluidisch vom Strömungsraum getrennt ist. Der Transferraum dient im Betrieb dem Wärmetransfer bzw. dem Wärmeaustauch mit dem Peltier-Element, das wiederum mit dem Strömungsraum bzw. dem durch den Strömungsraum strömenden Fluid Wärme austauscht. Hierdurch kommt es durch einen entsprechend durch das Peltier-Element verstärkten Wärmeaustausch zwischen dem Transferraum und dem durch den Strömungsraum strömenden Fluid. Das Peltier-Element weist eine Vielzahl von besagten Halbleitern auf, wobei p-dotierte P-Halbleiter und n-dotierte N-Halbleiter abwechselnd angeordnet sind. Die elektrische Verbindung der Halbleiter und somit besagte Leiter sind als eine Verbindungsstruktur realisiert. Die Verbindungsstruktur weist Verbindungselemente auf, die jeweils zwei solche Halbleiter elektrisch kontaktieren. Zudem sind die Halbleiter und die Verbindungselemente mechanisch miteinander verbunden. Die Halbleiter und die Verbindungselemente und somit die Halbleiter und die Verbindungsstruktur bilden hierbei eine mechanische und elektrische serielle Anordnung, in der jeweils ein solches Verbindungselement und ein solcher Halbleiter abwechselnd angeordnet sind.

Die serielle mechanische und elektrische Anordnung ist insbesondere derart realisiert, dass ein solches Verbindungselement zwei aufeinander folgende Halbleiter des Peltier-Elements sowohl mechanisch als auch elektrisch verbindet. Das heißt, dass entlang der Anordnung ein solcher P-Halbleiter, ein solches Verbindungselement, ein solcher N-Halbleiter, ein solches Verbindungselement, ein solcher P-Halbleiter usw. angeordnet sind.

Beim erfindungsgemäßen Wärmetauscher ist ferner eine einfache Integration des Peltier-Elements bzw. der Anordnung in den Wärmetauscher möglich. Insbesondere ist es möglich, das Peltier-Element vor etwaigen für die Herstellung des Wärmetauschers notwendigen Fügeverfahren, insbesondere vor einem Löten des Wärmetauschers, im Wärmetauscher anzuordnen. Hierdurch kann der Aufwand zur Herstellung des Wärmetauschers reduziert und somit die Herstellungskosten gesenkt werden.

Zudem können durch die erfindungsgemäße Lösung elektrisch isolierende Schichten, insbesondere elektrisch isolierende Platten, beispielsweise Keramikplatten zum elektrischen Isolieren des Peltier-Elements entfallen, so dass die Anzahl der Bestandteile des Wärmetauschers bzw. des Peltier-Elements reduziert und die Herstellung vereinfacht werden. Hierdurch wird auch das Gewicht des Peltier-Elements und somit des Wärmetauschers reduziert.

Bei vorteilhaften Ausführungsformen ist die serielle Anordnung als eine vorgefertigte Baueinheit ausgebildet, die in den Wärmetauscher einsetzbar bzw. montierbar ist. Hierdurch lässt sich der Herstellungsaufwand des Wärmetauschers erheblich reduzieren. Zudem können andere Herstellungsschritte zum Herstellen des Wärmetauschers unabhängig von der Anordnung und somit vom Peltier-Element erfolgen. Hierdurch kann der Wärmetauscher in mehreren Variationen und/oder kostengünstiger hergestellt werden. Die als vorgefertigte Baueinheit ausgebildete Anordnung ist also derart ausgestaltet, dass die Halbleiter gemeinsam mit den Verbindungselementen und somit mit der Verbindungsstruktur in den Wärmetauscher einsetzbar bzw. montierbar ist.

Die fluidische Trennung zwischen dem Strömungsraum und dem Transferraum kann prinzipiell auf beliebiger Weise realisiert sein.

Zur fluidischen Trennung des Strömungsraums vom Transferraum kommt vorzugsweise eine Trennstruktur zum Einsatz, die mehrere Trennelemente aufweist. Die Trennstruktur ist dabei vorteilhaft derart ausgestaltet, dass sie zusätzlich zur fluidischen Trennung den Strömungsraum und den Transferraum thermisch trennt. Die Trennelemente können hierbei insbesondere aus Materialien mit geringer thermischer Leitfähigkeit, beispielsweise aus Kunststoff, hergestellt sein. Die Trennelemente sind zweckmäßig aus einem elektrisch nicht leitenden Material hergestellt.

Vorstellbar ist es, dass die Trennelemente zwischen benachbarten Halbleitern verlaufen. In diesem Fall können die Halbleiter zusammen mit den Trennelementen die Trennstruktur ausbilden. Vorteilhaft ist es hierbei, wenn die Halbleiter zwischen Strömungsraum und Transferraum angeordnet sind.

Vorteilhafte Ausführungsformen sehen vor, dass die Baueinheit außer den Verbindungselementen und den Halbleitern auch die Trennelemente umfasst. Das heißt, dass die Baueinheit außer der seriellen Anordnung auch die Trennstruktur umfassen kann. Hierdurch wird die Herstellung des Wärmetauschers weiter vereinfacht, insbesondere der Montageaufwand weiter reduziert.

Das zu temperierende, durch den Strömungsraum strömende Fluid ist vorteilhaft elektrisch nicht leitend. Hierzu sollte das zu temperierende Fluid, insbesondere wenn es gasförmig ist, beispielsweise zu temperierende Luft, einen vorgegebenen Feuchtigkeitsanteil nicht überschreiten. Zum Begrenzen der Feuchtigkeit des Fluids ist es vorstellbar, den Wärmetauscher mit einer Entfeuchtungseinrichtung auszustatten, das Fluid stromauf des Peltier-Elements entfeuchtet.

Selbstverständlich kann mit dem erfindungsgemäßen Wärmetauscher auch ein flüssiges Fluid temperiert werden. Eine solche Temperierung ist insbesondere dann möglich, wenn die Flüssigkeit elektrisch nicht leitend ist bzw. eine vorgegebene elektrische Leitfähigkeit nicht überschreitet.

Bevorzugte Ausführungsformen sehen vor, dass die Verbindungselemente als Gleichteile ausgebildet sind. Hierdurch lässt sich der Herstellungsaufwand des Peltier-Elements und somit des Wärmetauschers reduzieren und/oder das Peltier-Element bzw. der Wärmetauscher kostengünstiger herstellen.

Der erfindungsgemäße Wärmetauscher kann in einer beliebigen Anwendung zum Temperieren eines solchen Fluids eingesetzt werden. Vorstellbar ist es insbesondere, den Wärmetauscher in einem Kraftfahrzeug einzusetzen, um ein durch das Kraftfahrzeug strömendes solches Fluid zu temperieren. Insbesondere kann der Wärmetauscher als Heizer, beispielsweise Zusatzheizer, zum Temperieren eines solchen Fluids eingesetzt werden. Dabei kann das Fluid insbesondere Luft sein, die einem Innenraum des Kraftfahrzeugs zugeführt wird. Folglich kommt der Wärmetauscher in diesem Fall als eine Klimatisierungseinrichtung des Kraftfahrzeugs oder als ein Teil einer solchen Klimatisierungseinrichtung zum Einsatz.

Der Wärmeaustausch im Transferraum mit dem Peltier-Element kann mit einem weiteren zweiten Fluid erfolgen, das nachfolgend als Temperierfluid bezeichnet wird. Hierbei ist der Transferraum vom Temperierfluid durchströmbar und kann dementsprechend als zweiter Strömungsraum bezeichnet werden. Dabei kann das zumindest eine im Temperierraum angeordnete Verbindungselement dem Temperierfluid direkt ausgesetzt sein. Das Temperierfluid ist vorzugsweise ein anderes Fluid als das durch den Strömungsraum strömende Fluid. Dabei kann das Temperierfluid ein Gas oder eine Flüssigkeit sein.

Beim Einsatz des Wärmetauschers in einem Kraftfahrzeug kann das Temperierfluid insbesondere Kühlwasser des Kraftfahrzeugs sein.)

Bevorzugt ist es, wenn zumindest ein solches Verbindungselement, das im Strömungsraum angeordnet ist, vom Fluid durchströmbar ist. Hierdurch kommt es zu einer Vergrößerung der mit dem Fluid wärmeaustauschenden Fläche des Verbindungselements und somit zu einem verbesserten Wärmeaustausch und folglich zu einer verbesserten Effizienz des Wärmetauschers.

Entsprechendes gilt für ein solches im Temperierraum bzw. im zweiten Strömungsraum angeordneten Verbindungselement, das vorzugsweise vom Temperierfluid durchströmbar ist, um die mit dem Temperierfluid wärmeaustauschende Fläche zu vergrößern und somit zu einer verbesserten Effizienz des Wärmetauschers beizutragen.

Der Wärmeaustausch des Peltier-Elements mit dem Transferraum kann ferner mit einem im Transferraum angeordneten Festkörper erfolgen. Hierbei ist es bevorzugt, wenn zumindest ein solches Verbindungselement wärmeübertragend mit dem Festkörper verbunden ist.

Vorteilhaft ist es, wenn zumindest ein solches Verbindungselement flächig am Festkörper anliegt. Hierdurch kommt es zu einer Vergrößerung der wärmeaustauschenden Fläche zwischen dem Verbindungselement und dem Festkörper und/oder zu einem verbesserten Grad an Wärmeaustausch zwischen dem Verbindungselement und dem Festkörper, so dass der Wärmeaustausch zwischen dem Festkörper und dem Verbindungselement erhöht und die Effizienz des Wärmetauschers gesteigert wird.

Der Festkörper kann also als eine Wärmequelle oder Wärmesenke dienen, von der das Peltier-Element Wärme abzieht bzw. dem das Peltier-Element Wärme zuführt.

Der Festkörper kann prinzipiell beliebig ausgebildet sein, sofern ein Wärmeaustausch zwischen dem Festkörper und dem zumindest einen Verbindungselement möglich ist.

Vorstellbar ist es beispielsweise, elektrisch isolierende Festkörper einzusetzen. Hierdurch kommt es zu keinem Kurzschluss zwischen den Verbindungselementen bzw. den Halbleitern, so dass ein Betrieb des Peltier-Elements nicht beeinträchtigt wird.

Vorstellbar ist es auch einen elektrisch leitenden Festkörper einzusetzen und diesen durch geeignete Mittel derart elektrisch zu isolieren, dass ein Kurzschluss zwischen den Verbindungselementen bzw. den Halbleitern unterbleibt. Ein solches Mittel kann insbesondere eine elektrisch isolierende Isolierschicht sein, mit der der Festkörper, insbesondere außenseitig zum elektrischen Isolieren von zumindest zwei solchen Verbindungselementen versehen ist.

Bevorzugte Ausführungsformen sehen vor, dass die vom Festkörper abgewandte Fläche eines solchen am Festkörper flächig anliegenden Verbindungselements durch zumindest ein solches Trennelement gegenüber dem Strömungsraum thermisch getrennt ist. Hierdurch wird ein unmittelbarer Wärmeaustausch zwischen diesem Verbindungselement und dem Strömungsraum verhindert oder zumindest reduziert. In der Folge kommt es zu einem verbesserten Wärmeaustausch des Verbindungselements und dementsprechend des Peltier-Elements mit dem Festkörper und folglich zu einer verbesserten Effizienz des Wärmetauschers.

Der Festkörper kann prinzipiell beliebig ausgebildet sein. Vorstellbar ist es insbesondere, den Festkörper massiv auszubilden.

Vorstellbar ist es auch, den Festkörper als einen Hohlkörper auszubilden. In einem solchen Fall kann der Festkörper durchströmbar sein, wobei die Durchströmung zur Temperierung des Hohlkörpers beiträgt. Insbesondere ist es vorstellbar, dass der Festkörper vom Temperierfluid durchströmbar ist. In diesem Fall ist der Festkörper also insbesondere als ein Rohr oder Rohrabschnitt für das Temperierfluid ausgebildet.

Bevorzugt ist es, wenn zumindest ein solches Verbindungselement, vorteilhaft alle Verbindungselemente, als Wärmeaustauschelemente zum unmittelbaren Wärmeaustausch mit dem Fluid, dem Temperierfluid bzw. dem Festkörper ausgebildet sind. Das heißt, dass die Verbindungselemente insbesondere keine thermisch isolierende Schicht und dergleichen aufweisen, die eine thermische Barriere für den Wärmeaustausch mit dem Verbindungselement bilden.

Das jeweilige Verbindungselement kann prinzipiell auf beliebiger Weise mit den zugehörigen Halbleitern verbunden sein.

Vorteilhafte Varianten sehen hierbei eine flächige Anlage zumindest eines solchen Verbindungselements an wenigstens einem der zugehörigen Halbleiter vor. Hierdurch wird eine wärmeaustauschende Fläche zwischen dem Verbindungselement und dem zumindest einem zugehörigen Halbleiter vergrößert und die Effizienz des Wärmetauschers somit erhöht.

Bei bevorzugten Ausführungsformen ist wenigstens ein solches Verbindungselement zum Ausgleich thermischer Spannungen elastisch ausgebildet. Die elastische Ausbildung des Verbindungselements kann dabei durch eine entsprechende Materialauswahl des Verbindungselements und/oder durch eine entsprechende Form des Verbindungselements realisiert sein. Vorstellbar ist es insbesondere, zumindest ein solches Verbindungselement aus einem Blech herzustellen und somit als ein Blechteil zu realisieren. Hierdurch ist eine einfache und kostengünstige Herstellung des Peltier-Elements möglich. Zudem ist es vorstellbar, zumindest ein solches Verbindungselement als eine in den Strömungsraum bzw. in den Transferraum abstehende Rippe auszubilden. Hierdurch wird der Wärmeaustausch zwischen dem Verbindungselement und dem Fluid bzw. zwischen dem Verbindungselement und dem Temperierfluid verbessert und die Effizienz des Wärmetauschers damit erhöht.

Die serielle Anordnung ist erfindungsmässig aus einem elektrisch leitenden Band, insbesondere aus einem Blech hergestellt. Das Band ist bevorzugt aus einem elektrisch leitenden Material, beispielsweise aus Aluminium, hergestellt. Hierbei kann zunächst das Band, insbesondere als ein Endlosband, bereitgestellt werden und anschließend abwechselnd mit P-Halbleitern und N-Halbleitern versehen werden, die entlang des Bandes mit Abstand zueinander angeordnet sind. Hierbei entstehen zwischen den Halbleitern besagte Verbindungselemente. Das Versehen des Bandes mit den Halbleitern erfolgt vorteilhaft derart, dass die Halbleiter mit dem Band verbunden sind.
Dabei können die Halbleiter unmittelbar am Band angebracht sein. Vorstellbar ist es insbesondere, das Band mit den Halbleitern zu beschichten. Hierzu können die Halbleiter im Zuge einer Sputterbeschichtung auf das Band aufgebracht werden.

Vorstellbar ist es ebenso, die Halbleiter auf einem geeigneten Träger anzubringen, die ihrerseits auf dem Band angebracht sind. Hierzu können beliebige Träger zum Einsatz kommen, auf denen sich der jeweilige Halbleiter anbringen lässt. Bevorzugt sind elektrisch leitende, insbesondere metallische Träger. Zu denken ist etwa an nickelhaltige Träger, beispielsweise Träger aus Nickel-Basis. Das Aufbringen der Halbleiter auf den Trägern kann beliebig erfolgen. Denkbar ist es insbesondere, die Träger mit den Halbleitern zu beschichten. Insbesondere können die Halbleiter durch eine Sputterbeschichtung auf die Träger aufgebracht werden. Die Verwendung von Trägern bietet den Vorteil, dass das Versehen mit den Halbleitern im Vergleich zum Band vereinfach erfolgen kann, da die Träger insbesondere kleinere Dimensionen aufweisen als das Band. Zudem ist hierdurch hinsichtlich des Aufbringens der Halbleiter vordergründig auf die Träger zu achten. Hierdurch kann das Band aus einem günstigeren Material hergestellt sein. Auch kann das Aufbringen der Halbleiter unabhängig vom Band, beispielsweise unter entsprechenden thermodynamischen Bedingungen, das heißt also bei geringen Drücken und/oder unter einer Schutzatmosphäre und/oder in einem Raum mit geringem Schmutz, insbesondere in einem Reinraum, erfolgen.

Das Aufbringen der Halbleiter auf den Trägern erfolgt bevorzugt vor dem Aufbringen der Träger auf das Band. Das heißt, dass mit solchen Halbleitern versehene Träger auf das Band angebracht werden.

Die Träger können auf beliebiger Weise am Band angebracht sein. Zu denken ist an stoffschlüssige und/oder formschlüssige Verbindungen, insbesondere an Varianten, bei denen die Träger mit dem Band verklebt, verlötet, verschweißt verklemmt, verstemmt oder gespannt werden. Dabei können die Träger und das Band zum Verbinden der Halbleiter entsprechend elektrisch miteinander verbunden sein. Vorstellbar ist es auch, die Halbleiter unmittelbar mit dem Band elektrisch zu kontaktieren.

Zur Realisierung der elektrischen seriellen Anordnung der Halbleiter kann eine entsprechende elektrische Unterbrechung des Bandes erfolgen. Hierzu kann das Band zunächst mit Aussparungen oder Unterbrechungen versehen werden, in die dann die Halbleiter bzw. die entsprechenden Träger versehen werden. Die Halbleiter können also insbesondere in die elektrischen Unterbrechungen des Bandes versehen werden.

Es versteht sich, dass der jeweilige Halbleiter nicht nur ein einziges Halbleiterelement sondern auch mehrere gleichartig dotierte Halbleiterelemente aufweisen kann.

Nach dem Versehen des Bandes mit den Halbleitern kann das Band auf eine gewünschte Länge geschnitten werden, um die serielle Anordnung in einer gewünschten Länge zu erhalten. Das Schneiden des Bandes auf die gewünschte Länge kann selbstverständlich auch vor dem Versehen des Bandes mit den Halbleitern erfolgen.

Die Anordnung kann eine beliebige Form aufweisen. Insbesondere können die Verbindungsstruktur und somit die Verbindungselemente eine beliebige Form aufweisen.

Vorstellbar ist es hierbei, das Band entsprechend der gewünschten Form der Anordnung umzuformen. Das Umformen des Bandes kann hierbei vor dem Versehen des Bandes mit den Halbleitern oder nach dem Versehen des Bandes mit den Halbleitern erfolgen. Vorstellbar ist es auch, das Band teilweise vor dem Versehen mit den Halbleitern und teilweise nach dem Versehen mit den Halbleitern umzuformen. Das Umformen erfolgt beispielsweise durch Stanzen und/oder Raffen.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: einen Schnitt durch einen thermoelektrischen Wärmetauscher eines Kraftfahrzeugs,
- Fig. 2: den Schnitt aus Fig. 1 bei einem anderen Ausführungsbeispiel des Wärmetauschers,
- Fig. 3: den Schnitt aus Fig. 2 bei einem weiteren Ausführungsbeispiel des Wärmetauschers,
- Fig. 4 bis 8: jeweils unterschiedliche Ausführungsbeispiele eines Peltier-Elements des Wärmetauschers,
- Fig. 9: einen Verfahrensschritt beim Herstellen einer Anordnung des Wärmetauschers,
- Fig. 10: den Schritt aus Fig. 9 bei einem anderen Ausführungsbeispiel,
- Fig. 11: eine Seitenansicht der Anordnung,
- Fig. 12 bis 14: Ansicht aus den Fig. 4 bis 8 bei jeweils einem weiteren Ausführungsbeispiel.

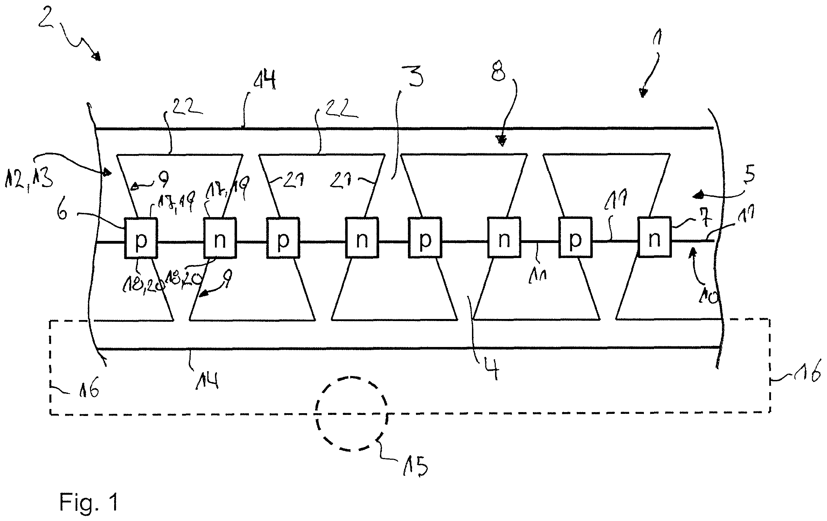

In Fig. 1 ist ein thermoelektrischer Wärmetauscher 1 eines ansonsten nicht gezeigten Kraftfahrzeugs 2 dargestellt. Der Wärmetauscher 1 weist einen Strömungsraum 3 sowie einen Transferraum 4 auf, die im Wesentlichen parallel verlaufen. Der Strömungsraum 3 ist von einem zu temperierenden Fluid durchströmbar, während der Transferraum 4 von einem anderen Fluid, das nachfolgend als Temperierfluid bezeichnet wird, durchströmbar ist. Der Wärmetauscher 1 weist zudem ein Peltier-Element 5 auf, das eine Vielzahl von entlang des Strömungsraums 3 bzw. des Transferraums 4 abwechselnd angeordneten p-dotierten P-Halbleitern 6 und n-dotieren N-Halbleitern 7 aufweist. Die Halbleiter 6, 7 sind mittels einer Verbindungsstruktur 8 miteinander elektrisch kontaktiert und in Reihe geschaltet. Die Verbindungsstruktur 8 weist hierzu eine Vielzahl von elektrisch leitenden Verbindungselementen 9 auf, wobei das jeweilige Verbindungselement 9 einen solchen P-Halbleiter 6 elektrisch mit dem benachbarten N-Halbleiter 7 kontaktiert. Eine Trennstruktur 10 trennt den Strömungsraum 3 und den Transferraum 4 fluidisch sowie thermisch. Hierzu weist die Trennstruktur 10 elektrisch isolierende Trennelemente 11 auf, welche zwischen den benachbarten Halbleitern 6, 7 verlaufen. Die Halbleiter 6, 7 sind hierbei zwischen dem Strömungsraum 3 und dem Transferraum 4 angeordnet, so dass sie zusammen mit den Trennelementen 11 die Trennstruktur 10 ausbilden.

Entlang des Strömungsraums bzw. des Transferraums 4, sind, jeweils abwechselnd, ein solches Verbindungselement 9 im Strömungsraum 3 und ein solches Verbindungselement 9 im Transferraum angeordnet. Hierdurch sind die Verbindungselemente 9 der Strömung des Fluids im Strömungsraum 3 bzw. der Strömung des Temperierfluids im Transferraum 4 unmittelbar ausgesetzt. Hierdurch kommt es zu einem unmittelbaren Wärmeaustausch der Verbindungselemente 9 mit dem Fluid bzw. dem Temperierfluid. Das heißt, dass die Verbindungselemente 9 bzw. die Verbindungsstruktur 8 sowohl der elektrischen Verbindung zwischen den Halbleitern 6, 7 dienen als auch zum Wärmeaustausch eingesetzt werden. Hierdurch wird die Effizienz des Wärmetauschers 1 erheblich verbessert.

Die Verbindungselemente 9 und die Halbleiter 6, 7 bilden dabei eine serielle Anordnung 12, in der jeweils ein solches Verbindungselement 9 und ein solcher Halbleiter 6, 7 abwechselnd angeordnet und sowohl elektrisch als auch mechanisch miteinander verbunden sind. Die Anordnung 12 ist dabei als eine Baueinheit 13 ausgebildet, die als solche in den Wärmetauscher 1 einsetzbar bzw. montierbar ist. Das heißt, dass die Anordnung 12 als eine die Verbindungselemente 9 bzw. die Verbindungsstruktur 8 sowie die Halbleiter 6, 7 aufweisende Baueinheit 13 realisiert ist, die separat in den Wärmetauscher 1 montierbar ist. Beim Montieren der Baueinheit 13 in den Wärmetauscher 1 wird die Baueinheit 13 dabei mechanisch und/oder elektrisch mit dem Wärmetauscher 1 verbunden. Vorstellbar ist es auch, dass die Trennstruktur 10, das heißt insbesondere auch die Trennelemente 11, zur Baueinheit 13 gehören.

Der Strömungsraum 3 sowie der Transferraum 4 werden auf der den Trennelementen 11 gegenüberliegenden Seiten von einer Wandung 14 begrenzt.

Beim Anlegen einer elektrischen Spannung an das Peltier-Element 5, beispielsweise über eine Spannungsquelle 15 und elektrische Kabel 16, entstehen am Peltier-Element 5 bedingt durch den Peltiereffekt eine erste Temperaturseite 17, die im gezeigten Beispiel dem Strömungsraum 3 zugewandt und die im Strömungsraum 3 angeordnet ist, und eine zweite Temperaturseite 18, die im gezeigten Beispiel dem Transferraum 4 zugewandt und im Transferraum 4 angeordnet ist. Durch eine entsprechende Wahl der angelegten Spannung kann die erste Temperaturseite 17 eine höhere Temperatur aufweisen als die zweite Temperaturseite 18 oder umgekehrt. Im gezeigten Beispiel ist die Spannung derart angelegt, dass die erste Temperaturseite 17 eine höhere Temperatur aufweist als die zweite Temperaturseite 18. Die erste Temperaturseite 17 ist somit eine Warmseite 19 des Peltier-Elements, während die zweite Temperaturseite 18 eine Kaltseite 20 des Peltier-Elements 5 ist. Somit wird dem durch den Strömungsraum 3 strömende Fluid Wärme zugeführt, während vom durch den Transferraum 4 strömenden Temperierfluid Wärme entzogen und das Temperierfluid somit gekühlt wird. Der Peltiereffekt sorgt hierbei dafür, dass die vom Temperierfluid auf das durch den Strömungsraum 3 strömende Fluid übertragene Wärme größer ist als bei einem direkten Wärmeübertrag.

Die Verbindungselemente 9 sind aus einem Blech, insbesondere aus Aluminiumblech, hergestellt und sind zum Ausgleich thermischer Spannungen elastisch ausgebildet. Das heißt, dass thermische Spannungen innerhalb des Peltier-Elements 5 durch eine entsprechende Verformung der elastisch ausgebildeten Verbindungselemente 9 ausgeglichen werden können.

Das jeweilige Verbindungselement 9 weist von den zugehörigen Halbleitern 6, 7 in entgegengesetzten Richtungen abstehende Schenkel 21 und eine die Schenkel 21 auf der von den zugehörigen Halbleitern 6, 7 gegenüberliegenden Seite verbindende Grundseite 22 auf. Dabei sind die im Strömungsraum 3 angeordneten Verbindungselemente 9 vom durch den Strömungsraum 3 strömenden Fluid durchströmbar. Hierdurch kommt es zu einem verbesserten Wärmeaustausch zwischen den Verbindungselementen 9 und dem Fluid. Entsprechendes gilt für die im Transferraum 4 angeordneten Verbindungselemente 9, die vom Temperierfluid durchströmbar sind und somit eine vergrößerte Fläche zum Wärmeaustausch mit dem Temperierfluid zur Verfügung stellen. In Fig. 1 ist ferner zu erkennen, dass sämtliche Verbindungselemente 9, das heißt sowohl die im Strömungsraum 3 angeordneten Verbindungselemente 9 als auch die im Transferraum 4 angeordneten Verbindungselemente 9 als Gleichteile ausgebildet sind.

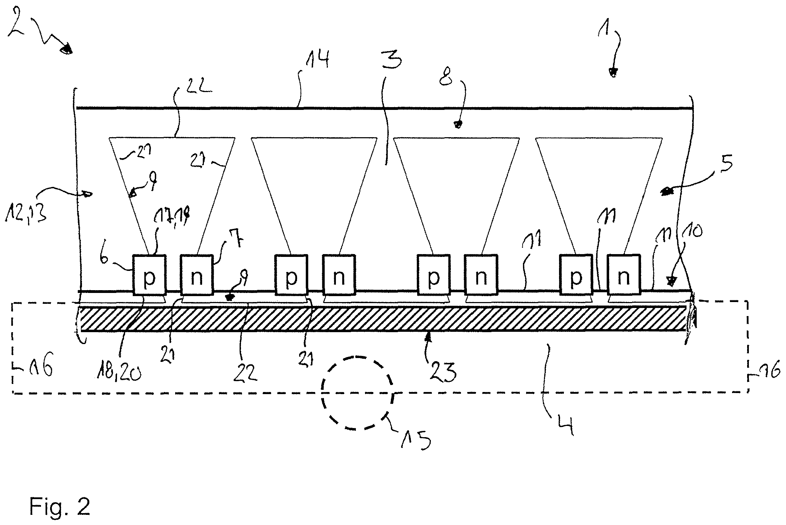

In Fig. 2 ist ein anderes Ausführungsbeispiel des Wärmetauschers 1 dargestellt. Im Gegensatz zum in Fig. 1 dargestellten Ausführungsbeispiel ist in Fig. 2 im Transferraum 4 ein Festkörper 23 angeordnet, der mit dem Peltier-Element 5 Wärme austauscht. Dabei sind die im Transferraum 4 angeordneten Verbindungselement 9 in wärmetauschendem Kontakt mit dem Festkörper 23.

Hierzu liegen die Verbindungselemente 9 im gezeigten Beispiel mit ihren Grundseiten 22 flächig am Festkörper 23 an. In der Darstellung sind dabei die Verbindungselement 9 zum besseren Verständnis beabstandet zum Festkörper 23 angeordnet. Hierdurch kommt es zu einem verbesserten Wärmeaustausch zwischen dem Festkörper 23 und den im Transferraum 4 angeordneten Verbindungselementen 9 und somit zu einem verbesserten Wärmeaustausch zwischen dem Festkörper 23 und dem Peltier-Element 5. In Fig. 2 ist dabei zu erkennen, dass die im Transferraum 4 angeordneten Verbindungselemente 9 kleinere bzw. kürzere Schenkel 21 aufweisen, als die im Strömungsraum 3 angeordneten Verbindungselemente 9. Dabei ist im gezeigten Beispiel die Spannung so angelegt, dass die dem Festkörper 23 zugewandten Seiten der Halbleiter 6, 7 die Kaltseite 20 sind. Dementsprechend wird im Betrieb des Wärmetauschers 1 Wärme vom Festkörper 23 abgeführt und dem durch den Strömungsraum 3 strömenden Fluid zugeführt. Um einen Kurzschluss zwischen den im Transferraum 4 angeordneten Verbindungselementen 9 zu vermeiden, kann der Festkörper 23 elektrisch isolierend sein. Vorstellbar ist es auch, dass der Festkörper 23 elektrisch leitend ist und zum elektrischen Isolieren gegenüber den Verbindungselementen 9 eine nicht gezeigte elektrisch isolierende Isolierschicht aufweist. Wie in Fig. 2 ferner zu erkennen ist, ist die vom Festkörper 23 abgewandte Fläche der am Festkörper 23 flächig anliegenden Verbindungselemente 9 mittels jeweils eines solchen Trennelements 11 gegenüber dem Strömungsraum 3 thermisch getrennt. Hierdurch erfolgt bevorzugt auch eine thermische Trennung der entsprechenden Verbindungselemente 9 vom Strömungsraum, um einen unmittelbaren Wärmeaustausch der entsprechenden Verbindungselemente 9 mit dem durch den Strömungsraum 3 strömenden Fluid zu verhindern oder zumindest zu reduzieren.

Der im Fig. 2 gezeigte Festkörper 23 ist, wie durch die schraffierte Darstellung angedeutet, massiv ausgebildet. Der massiv ausgebildete Festkörper 23 kann hierbei eine Wandung eines zu temperierenden, im Übrigen nicht gezeigten Bauteils, insbesondere des Kraftfahrzeugs 2, sein.

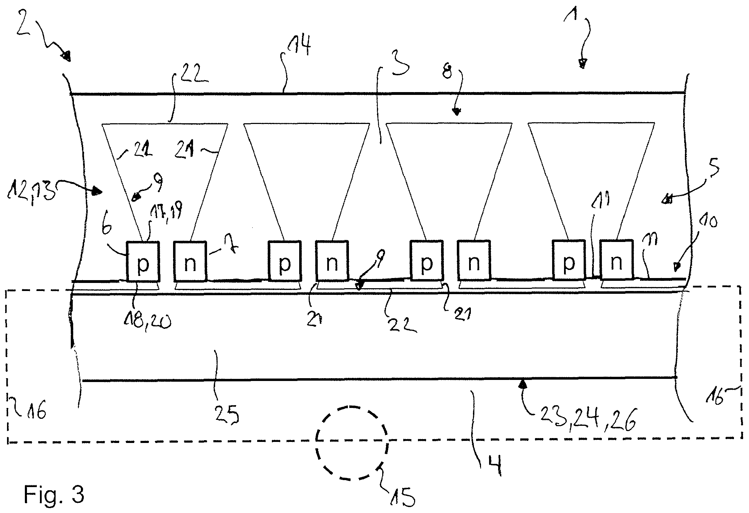

In Fig. 3 ist ein anderes Ausführungsbeispiel des Wärmetauschers 1 dargestellt, das sich vom in Fig. 2 gezeigten Ausführungsbeispiel im Wesentlichen dadurch unterscheidet, dass der Festkörper 23 als ein Hohlkörper 24 ausgebildet ist. Der Hohlkörper 24 kann hierbei vom Temperierfluid durchströmbar sein und somit einen entsprechenden Strömungsraum 25 für das Temperierfluid begrenzen, wobei dieser Strömungsraum 25 nachfolgend als zweiter Strömungsraum 25 bezeichnet wird. Das Temperierfluid strömt also durch den zweiten Strömungsraum 25 wodurch der als Hohlkörper 24 ausgebildete Festkörper 23 eine entsprechende Temperatur annimmt. Der somit erwärmte oder gekühlte Festkörper 23 steht über die im Transferraum 4 angeordneten Verbindungselemente 9 mit dem Peltier-Element 5 in wärmeübertragendem Kontakt, um das durch den Strömungsraum 3 strömende Fluid zu temperieren. Der als Hohlkörper 24 ausgebildete Festkörper 23 kann also insbesondere ein Rohr 26 sein.

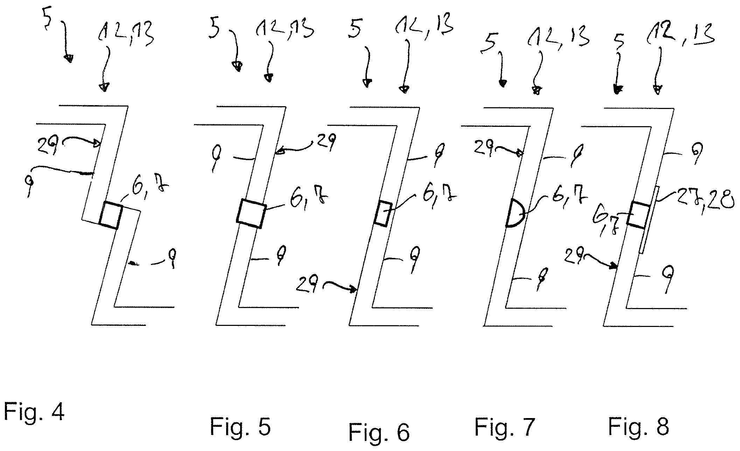

In den Fig. 4 bis 8 sind verschiedene Ausführungsbeispiele des Peltier-Elements 5 bzw. der Anordnung 12 dargestellt, wobei jeweils ein solcher Halbleiter 6, 7 samt zugehörigen Verbindungselementen 9 zu sehen ist.

Bei dem in Fig. 4 gezeigten Ausführungsbeispiel ist der Halbleiter 6, 7 mit Versatz zwischen den Verbindungselementen 9 angeordnet bzw. angebracht.

Bei dem in Fig. 5 gezeigten Ausführungsbeispiel ist der Halbleiter 6, 7 ohne Versatz zwischen den Verbindungselementen 9 eingebracht bzw. angeordnet.

In Fig. 6 ist ein Ausführungsbeispiel zu sehen, bei dem der Halbleiter 6, 7 ohne Versatz zwischen den Verbindungselementen 9 angebracht ist, wobei die Verbindungselemente 9 unmittelbar miteinander verbunden bzw. durchgehend ausgebildet sind. Hierbei können die Verbindungselemente 9 insbesondere einstückig, das heißt beispielsweise materialeinheitlich, ausgebildet sein.

In Fig. 7 ist ein Ausführungsbeispiel gezeigt, das sich von dem in Fig. 6 gezeigten Beispiel im Wesentlichen dadurch unterscheidet, dass der Halbleiter 6, 7 gebogen ausgebildet ist. Im gezeigten Beispiel weist der Halbleiter 6, 7 dabei einen halbkreisförmigen Querschnitt auf. Ein Krümmungsradius des Halbleiters 6, 7 ist der entsprechenden Gegebenheiten, insbesondere einer verbesserten Fertigung, angepasst.

In Fig. 8 ist ein Ausführungsbeispiel zu sehen, bei dem der Halbleiter 6, 7 ohne Versatz zwischen den Verbindungselementen 9 angeordnet ist. Dabei ist zusätzlich ein Stabilisationselement 27 zur Stabilisation der Verbindungselemente 9 und/oder zum Tragen der Verbindungselemente 9 außenseitig an den Verbindungselementen 9 angebracht. Das Stabilisationselement 27 ist vorzugsweise elektrisch nicht leitend, insbesondere elektrisch isolierend. Das Stabilisationselement 27 kann als eine auf die Verbindungselemente 9 aufgebrachte, nicht leitende Stabilisationsschicht 28 ausgebildet sein.

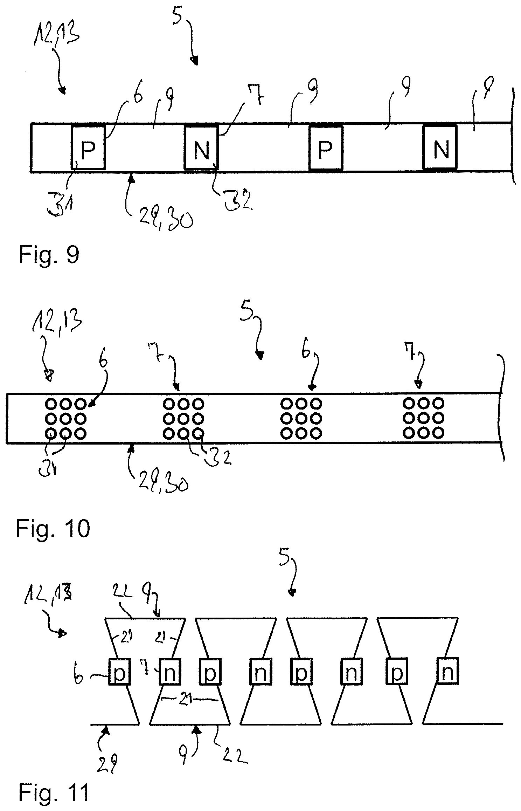

In Fig. 9 ist ein Schritt bei einer bevorzugten Herstellung der Anordnung 12 bzw. des Peltier-Elements 5 dargestellt. Dabei wird zunächst ein Band 29, insbesondere ein Endlosband 30, insbesondere aus Aluminium, bereitgestellt. Entlang des Bandes 29 wird das Band 29 in vorgegebenen Abständen jeweils abwechselnd mit einem solchen P-Halbleiter 6 und einem N-Halbleiter 7 versehen. Hierdurch entstehen zwischen den Halbleitern 6, 7 die Verbindungselemente 9. Beim in Fig. 9 gezeigten Ausführungsbeispiel weist der jeweilige Halbleiter 6, 7 ein zugehöriges Halbleiterelement 31, 32 auf.

In Fig. 10 ist ein Ausführungsbeispiel dargestellt, bei dem das Band 29 mit solchen Halbleitern 6, 7 versehen wird, die mehrere solche gleichartig dotierte Halbleiterelemente 31, 32, aufweisen. Das heißt, dass der jeweilige P-Halbleiter 6 mehrere p-dotierte P-Halbleiterelemente 31 aufweist, während der jeweilige N-Halbleiter 7 mehrere n-dotierte N-Halbleiterelemente 32 aufweist.

Bei beiden Ausführungsbeispielen kann ein Schneiden des Bandes 29 auf eine gewünschte Länge erfolgen. Das Schneiden des Bandes 29 auf die gewünschte Länge kann hierbei vor dem Versehen des Bandes 29 mit den Halbleitern 6, 7 oder nach dem Versehen des Bandes 29 mit den Halbleitern 6, 7 erfolgen.

Fig. 11 zeigt einen weiteren Verfahrensschritt zum Herstellen des Peltier-Elements 5 bzw. der Anordnung 12, bei dem das mit den Halbleitern 6, 7 versehene Band 29 in die gewünschte Form umgeformt wird. In Fig. 11 erfolgt diese Umformung dabei derart, dass das Peltier-Element 5 bzw. die Anordnung 12 des in Fig. 1 gezeigten Wärmetauschers 1 entsteht. Durch eine entsprechende unterschiedliche Anordnung der Halbleiter 6, 7 und Umformung kann auch das in den Fig. 2 und 3 gezeigte Peltier-Element 5 bzw. die entsprechende Anordnung 12 hergestellt werden.

Vorstellbar ist es hierbei auch, die Umformung des Bandes vor dem Versehen des Bandes 29 mit den Halbleitern 6, 7 vorzunehmen.

Die in Fig. 9 bis 11 gezeigten Anordnungen 12 sind dabei solche Baueinheiten 13. Vorstellbar ist es dabei, die jeweilige Anordnung 12 bzw. Baueinheit 13 mit der Trennstruktur 10 bzw. den Trennelementen 11 zu versehen, so dass die Baueinheit 13 auch die Trennstruktur 12 bzw. die Trennelemente 11 umfasst.

Das Versehen des Bandes mit den Halbleitern 6, 7 und das Umformen des Bandes 29 kann ebenso derart erfolgen, dass sich hierdurch die in den Fig. 4 bis 8 dargestellten Ausführungsbeispiele ergeben.

Bei den in den Fig. 4 bis 8 sowie 9 und 10 gezeigten Ausführungsbeispielen sind die Halbleiter 6, 7 unmittelbar auf das Band 29 bzw. den Verbindungselementen 9 aufgebracht. Dies erfolgt beispielsweise durch eine entsprechende Beschichtung des Bands 29 bzw. der Verbindungselemente 9 mit den Halbleitern 6, 7. Hierzu kann beispielsweise eine Sputterbeschichtung zum Einsatz kommen.

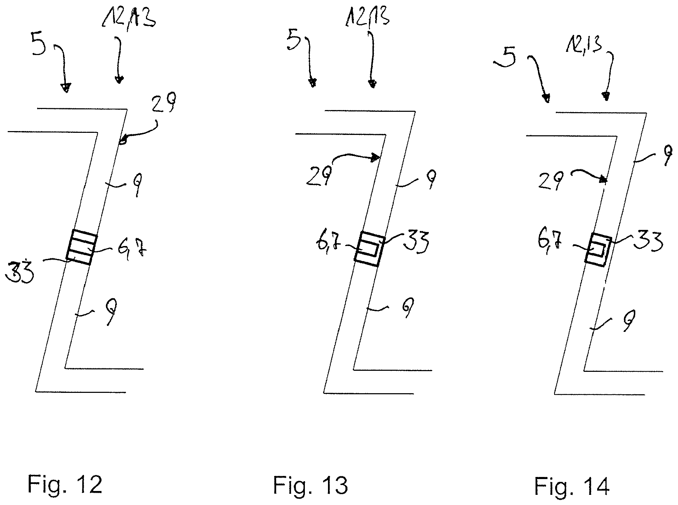

In den Figuren 12 bis 14 sind weitere Ausführungsbeispiele gezeigt, bei denen der Halbleiter 6, 7 auf einen zugehörigen Träger 33 aufgebracht ist, der auf das Band 29 aufgebracht ist bzw. der mit den Verbindungselementen 9 verbunden ist. Das heißt, dass der jeweilige Halbleiter 6, 7 auf einem solchen zugehörigen Träger 33 aufgebracht ist, der mit dem Band 29 bzw. den zugehörigen Verbindungselementen 9 verbunden ist. Der Träger 33 ist aus einem elektrisch leitenden Material. Dabei werden die Träger 33 zunächst mit den Halbleitern 6, 7 versehen und die mit dem Halbleitern 6, 7 versehenen Träger 33 anschließend auf das Band 29 aufgebracht bzw. mit den zugehörigen Verbindungselementen 9 verbunden, insbesondere verklebt, verlötet, verschweißt und dergleichen. Das Versehen der Träger 33 mit den Halbleitern 6, 7 erfolgt durch eine Beschichtung der Träger 33, insbesondere durch eine Sputterbeschichtung.

Das Band 29 kann vor dem Versehen mit den Halbleitern 6, 7 bzw. den Trägern 33 mit elektrischen Unterbrechungen versehen werden, um die elektrische serielle Anordnung der Halbleiter 6, 7 zu realisieren. Hierzu kann das Band 29 mit entsprechenden, nicht sichtbaren Aussparungen bzw. Nuten versehen werden, in die dann die Halbleiter 6, 7 bzw. die Träger 33 versehen, insbesondere eingebracht, werden.

Dabei ist in Fig. 12 ein Ausführungsbeispiel gezeigt bei dem der Halbleiter 6, 7 den Träger 33 in einer Richtung im Wesentlichen überdeckt, während der Träger 33 senkrecht dazu größer ist als der Halbleiter 6, 7.

In Fig. 13 ist der Träger 33 in beiden Richtungen größer als der Halbleiter 6, 7. Bei den in Fig. 12 und Fig. 13 gezeigten Ausführungsbeispielen überdecken die Träger 33 dabei das Band 29 bzw. die Verbindungselemente 9 in einer Richtung. In diesen Beispielen kann der Träger 33 die Verbindungselemente 9 miteinander mechanisch und/oder elektrisch verbinden.

Beim im Fig. 14 gezeigten Ausführungsbeispiel bedeckt der Träger 33 das Band 29 bzw. die Verbindungselemente 9 lediglich teilweise. Der Träger 33 ist dabei in beiden Richtungen größer als der Halbleiter 6, 7. *****

## Patentansprüche

1. Verfahren zum Herstellen einer elektrischen und mechanischen seriellen Anordnung (12) in einem thermoelektrischen Wärmetauscher (1) zum Temperieren eines Fluides, wobei der Wärmetauscher (1) einen vom zu temperierenden Fluid durchströmbaren Strömungsraum (3) und einen vom Strömungsraum (3) fluidisch getrennten Transferraum (4) sowie ein Peltier-Element (5), das eine Vielzahl von abwechselnd angeordneten p-dotierten P-Halbleitern (6) und n-dotierten N-Halbleitern (7) aufweist, aufweist,
- wobei die Halbleiter (6, 7) durch eine Verbindungsstruktur (8) elektrisch kontaktiert sind, die jeweils zwei solche Halbleiter (6, 7) elektrisch kontaktierende Verbindungselemente (9) aufweist,
- wobei zumindest ein solches Verbindungselement (9) im Strömungsraum (3) angeordnet ist und/oder zumindest ein solches Verbindungselement (9) im Transferraum (4) angeordnet ist,
- wobei die Halbleiter (6, 7) und die Verbindungselemente (9) die elektrische und mechanische serielle Anordnung (12) bilden, in der jeweils ein solches Verbindungselement (9) und ein solcher Halbleiter (6, 7) abwechselnd angeordnet ist,
**gekennzeichnet durch** die Verfahrensschritte:
- Bereitstellen eines elektrisch leitenden Bandes (29),
- Abwechselndes Versehen des Bandes (29) mit p-dotierten P-Halbleitern (6) und n-dotierten N-Halbleitern (7) entlang des Bandes (29), wobei zwischen den Halbleitern (6, 7) besagte Verbindungselemente (9) entstehen.

2. Verfahren nach Anspruch 1,
**dadurch gekennzeichnet,**
**dass** das Band (29) nach dem Versehen mit den Halbleitern (6, 7) oder vor dem Versehen mit den Halbleitern (6, 7) auf eine gewünschte Länge geschnitten wird.

3. Verfahren nach Anspruch 1 oder 2,
**dadurch gekennzeichnet,**
**dass** das das Band (29) nach dem Versehen mit den Halbleitern (6, 7) oder vor dem Versehen mit den Halbleitern (6, 7) umgeformt wird.

4. Thermoelektrischer Wärmetauscher (1) zum Temperieren eines Fluides, insbesondere für ein Kraftfahrzeug (2),
- mit einem vom zu temperierenden Fluid durchströmbaren Strömungsraum (3),
- mit einem vom Strömungsraum (3) fluidisch getrennten Transferraum (4),
- mit einem Peltier-Element (5), das eine Vielzahl von abwechselnd angeordneten p-dotierten P-Halbleitern (6) und n-dotierten N-Halbleitern (7) aufweist,
- wobei die Halbleiter (6, 7) durch eine Verbindungsstruktur (8) elektrisch kontaktiert sind, die jeweils zwei solche Halbleiter (6, 7) elektrisch kontaktierende Verbindungselemente (9) aufweist,
- wobei zumindest ein solches Verbindungselement (9) im Strömungsraum (3) angeordnet ist und/oder zumindest ein solches Verbindungselement (9) im Transferraum (4) angeordnet ist,
- wobei die Halbleiter (6, 7) und die Verbindungselemente (9) eine elektrische und mechanische serielle Anordnung (12) bilden, in der jeweils ein solches Verbindungselement (9) und ein solcher Halbleiter (6, 7) abwechselnd angeordnet ist,
- wobei die Anordnung (12) gemäß dem Verfahren nach einem der Ansprüche 1 bis 3 hergestellt ist.

5. Wärmetauscher nach Anspruch 4,
**dadurch gekennzeichnet,**
**dass** die Anordnung (12) als eine vorgefertigte Baueinheit (13) ausgebildet ist, die in den Wärmetauscher (1) einsetzbar ist.

6. Wärmetauscher nach Anspruch 4 oder 5,
**dadurch gekennzeichnet,**
**dass** eine Trennelemente (11) aufweisende Trennstruktur (10) den Strömungsraum (3) und den Transferraum (4) fluidisch und thermisch trennt.

7. Wärmetauscher nach Anspruch 6,
**dadurch gekennzeichnet,**
**dass** die Halbleiter (6, 7) zusammen mit den Trennelementen (11) die Trennstruktur (10) ausbilden.

8. Wärmetauscher nach Anspruch 5 und Anspruch 6 oder 7,
**dadurch gekennzeichnet,**
**dass** die Baueinheit (13) die Trennelemente (11) umfasst.

9. Wärmetauscher nach einem der Ansprüche 4 bis 8,
**dadurch gekennzeichnet,**
**dass** der Transferraum (4) von einem mit dem Peltier-Element (5) wärmeaustauschendem Temperierfluid durchströmbar ist.

10. Wärmetauscher nach einem der Ansprüche 4 bis 9,
**dadurch gekennzeichnet,**
**dass** im Transferraum (4) ein mit dem Peltier-Element (5) wärmeaustauschender Festkörper (23) angeordnet ist.

11. Wärmetauscher nach Anspruch 10,
**dadurch gekennzeichnet,**
**dass** wenigstens ein solches Verbindungselement (9) flächig am Festkörper (23) anliegt.

12. Wärmeübertrager nach Anspruch 10 oder 11,
**dadurch gekennzeichnet,**
- **dass** der Festkörper (23) elektrisch isolierend ist, oder
- **dass** der Festkörper (23) zum elektrischen Isolieren gegenüber zumindest einem solchen Verbindungselement (9) mit einer elektrisch isolierenden Isolierschicht versehen ist.

13. Wärmetauscher nach Anspruch 6 und Anspruch 11 oder 12,
**dadurch gekennzeichnet,**
**dass** die vom Festkörper (23) abgewandte Fläche eines solchen am Festkörper flächig anliegenden Verbindungselements (9) durch zumindest ein solches Trennelement (11) gegenüber dem Strömungsraum (3) thermisch getrennt ist.

14. Wärmetauscher nach einem der Ansprüche 10 bis 13,
**dadurch gekennzeichnet,**
- **dass** der Festkörper (23) massiv ausgebildet ist, oder
- **dass** der Festkörper (23) als ein vom Temperierfluid durchströmbarer Hohlkörper (24) ausgebildet ist.

15. Wärmetauscher nach einem der Ansprüche 4 bis 14,
**dadurch gekennzeichnet,**
**dass** wenigstens ein solches Verbindungselement (9) zum Ausgleich thermischer Spannungen elastisch ausgebildet ist.

## Claims

1. Method for producing an electrical and mechanical serial arrangement (12) in a thermoelectric heat exchanger (1) for regulating the temperature of a fluid, wherein the heat exchanger (1) has a flow chamber (3) which can be flowed through by a temperature-regulating fluid and a transfer chamber (4) separated fluidically from the flow chamber (3) as well as a Peltier element (5) which has a plurality of alternately arranged p-doped P-semiconductors (6) and n-doped N-semiconductors (7),
- wherein the semiconductors (6, 7) are contacted electrically by a connecting structure (8) which has connecting elements (9) electrically contacting two such semiconductors (6, 7),
- wherein at least one such connecting element (9) is arranged in the flow chamber (3) and/or at least one such connecting element (9) is arranged in the transfer chamber (4),
- wherein the semiconductors (6, 7) and the connecting elements (9) form the electrical and mechanical serial arrangement (12) in which one such connecting element (9) and one such semiconductor (6, 7) are arranged alternately,
**characterised by** the method steps:
- providing an electroconductive band (29),
- alternately providing the band (29) with p-doped P-semiconductors (6) and n-doped N-semiconductors (7) along the band (29), wherein said connecting elements (9) are formed between the semiconductors (6, 7).

2. Method according to claim 1,
**characterised in that**
the band (29) is cut to a desired length after being provided with the semiconductors (6, 7) or before being provided with the semiconductors (6, 7).

3. Method according to claim 1 or 2,
**characterised in that**
the band (29) is shaped after being provided with the semiconductors (6, 7) or before being provided with the semiconductors (6, 7).

4. Thermoelectric heat exchanger (1) for regulating the temperature of a fluid, in particular for a motor vehicle (2),
- with a flow chamber (3) which can be flowed through by a fluid for regulating temperature,
- with a transfer chamber (4) separated fluidically from the flow chamber (3),
- with a Peltier element (5) which has a plurality of alternately arranged p-doped P-semiconductors (6) and n-doped N-semi-conductors (7),
- wherein the semiconductors (6, 7) are contacted electrically by a connecting structure (8) which has connecting elements (9) electrically contacting two such semiconductors (6, 7),
- wherein at least one such connecting element (9) is arranged in the flow chamber (3) and/or at least one such connecting element (9) is arranged in the transfer chamber (4),
- wherein the semiconductors (6, 7) and the connecting elements (9) form an electrical and mechanical serial arrangement (12) in which one such connecting element (9) and one such semiconductor (6, 7) is arranged alternately,
- wherein the arrangement (12) is produced according to the method according to any of claims 1 to 3.

5. Heat exchanger according to claim 4,
**characterised in that**
the arrangement (12) is designed as a prefabricated unit (13) which can be inserted into the heat exchanger (1).

6. Heat exchanger according to claim 4 or 5,
**characterised in that**
a separating structure (10) having separating elements (11) separates the flow chamber (3) and the transfer chamber (4) fluidically and thermally.

7. Heat exchanger according to claim 6,
**characterised in that**
the semi-conductors (6, 7) form the separating structure (10) together with the separating elements (11).

8. Heat exchanger according to claim 5 and claim 6 or 7,
**characterised in that**
the unit (13) comprises the separating elements (11).

9. Heat exchanger according to any of claims 4 to 8,
**characterised in that**
the transfer chamber (4) can be flowed through by a temperature-regulating fluid exchanging heat with the Peltier element (5).

10. Heat exchanger according to any of claims 4 to 9,
**characterised in that**
in the transfer chamber (4) a solid body (23) is arranged which exchanges heat with the Peltier element (5).

11. Heat exchanger according to claim 10,
**characterised in that**
at least one such connecting element (9) bears flat on the solid body (23).

12. Heat exchanger according to claim 10 or 11,
**characterised in that**
- the solid body (23) is electrically insulating or
- the solid body (23) is provided with an electrically insulating layer for electrical insulation from at least one such connecting element (9).

13. Heat exchanger according to claim 6 and claim 11 or 12,
**characterised in that**
the surface facing away from the solid body (23) of such a connecting element (9) bearing flat on the solid body is thermally separated by at least one such separating element (11) from the flow chamber (3).

14. Heat exchanger according to any of claims 10 to 13,
**characterised in that**
- the solid body (23) is designed to be solid, or
- the solid body (23) is designed as a hollow body (24) which can be flowed through by a fluid for regulating temperature.

15. Heat exchanger according to any of claims 4 to 14,
**characterised in that**
at least one such connecting element (9) is designed to be elastic for equalising thermal stresses.

## Revendications

1. Procédé de production d'un agencement électrique et mécanique en série (12) au sein d'un échangeur de chaleur thermoélectrique (1) pour la régulation de température d'un fluide, dans lequel l'échangeur de chaleur (1) présente un espace de circulation (3) pouvant être parcouru par le fluide à réguler en température et un espace de transfert (4) séparé fluidiquement de l'espace de circulation (3) ainsi qu'un élément à effet Peltier (5) présentant une pluralité de semi-conducteurs de type P (6) à dopage p et de semi-conducteurs de type N (7) à dopage n, agencés de manière alternée,
- dans lequel les semi-conducteurs (6, 7) sont mis en contact électrique grâce à une structure de liaison (8) qui présente des éléments de liaison (9) mettant en contact électrique respectivement deux tels semi-conducteurs (6, 7),
- dans lequel au moins un tel élément de liaison (9) est agencé dans l'espace de circulation (3) et/ou au moins un tel élément de liaison (9) est agencé dans l'espace de transfert (4),
- dans lequel les semi-conducteurs (6, 7) et les éléments de liaison (9) forment l'agencement électrique et mécanique en série (12) au sein duquel sont agencés de manière alternée un tel élément de liaison (9) et un tel semi-conducteur (6, 7),
**caractérisé par** les étapes de procédé consistant à :
- fournir une bande électriquement conductrice (29),
- munir de manière alternée la bande (29) de semi-conducteurs de type P (6) à dopage p et de semi-conducteurs de type N (7) à dopage n le long de la bande (29), dans lequel lesdits éléments de liaison (9) sont formés entre les semi-conducteurs (6, 7).

2. Procédé selon la revendication 1,
**caractérisé en ce que**
la bande (29) est coupée à une longueur souhaitée après avoir été munie des semi-conducteurs (6, 7) ou avant d'avoir été munie des semi-conducteurs (6, 7).

3. Procédé selon la revendication 1 ou 2,
**caractérisé en ce que**
la bande (29) est transformée après avoir été munie des semi-conducteurs (6, 7) ou avant d'avoir été munie des semi-conducteurs (6, 7).

4. Échangeur de chaleur thermoélectrique (1) pour la régulation de température d'un fluide, en particulier pour un véhicule automobile (2),
- avec un espace de circulation (3) pouvant être parcouru par le fluide à réguler en température,
- avec une chambre de transfert (4) séparée fluidiquement de l'espace de circulation (3),
- avec un élément à effet Peltier (5) présentant une pluralité de semi-conducteurs de type P (6) à dopage p et de semi-conducteurs de type N (7) à dopage n, agencés de manière alternée,
- dans lequel les semi-conducteurs (6, 7) sont mis en contact électrique grâce à une structure de liaison (8) qui présente des éléments de liaison (9) mettant en contact électrique respectivement deux tels semi-conducteurs (6, 7),
- dans lequel au moins un tel élément de liaison (9) est agencé dans l'espace de circulation (3) et/ou au moins un tel élément de liaison (9) est agencé dans l'espace de transfert (4),
- dans lequel les semi-conducteurs (6, 7) et les éléments de liaison (9) forment un agencement électrique et mécanique en série (12) au sein duquel sont agencés de manière alternée un tel élément de liaison (9) et un tel semi-conducteur (6, 7),
- dans lequel l'agencement (12) est produit conformément au procédé selon l'une quelconque des revendications 1 à 3.

5. Échangeur de chaleur selon la revendication 4,
**caractérisé en ce que**,
l'agencement (12) est conçu comme une unité structurelle préfabriquée (13) pouvant être insérée dans l'échangeur de chaleur (1).

6. Échangeur de chaleur selon la revendication 4 ou 5,
**caractérisé en ce que**,
une structure de séparation (10) présentant des éléments de séparation (11) sépare de manière fluidique et de manière thermique l'espace de circulation (3) et l'espace de transfert (4).

7. Échangeur de chaleur selon la revendication 6,
**caractérisé en ce que**,
les semi-conducteurs (6, 7) forment la structure de séparation (10) avec les éléments de séparation (11).

8. Échangeur de chaleur selon la revendication 5 et la revendication 6 ou 7,
**caractérisé en ce que**,
l'unité structurelle (13) comprend les éléments de séparation (11).

9. Échangeur de chaleur selon l'une quelconque des revendications 4 à 8,
**caractérisé en ce que**,
l'espace de transfert (4) peut être parcouru par un fluide de régulation de température échangeant de la chaleur avec l'élément à effet Peltier (5).

10. Échangeur de chaleur selon l'une quelconque des revendications 4 à 9,
**caractérisé en ce que**,
un corps solide (23) échangeant de la chaleur avec l'élément à effet Peltier (5) est agencé dans l'espace de transfert (4).

11. Échangeur de chaleur selon la revendication 10,
**caractérisé en ce que**,
au moins un tel élément de liaison (9) repose à plat sur le corps solide (23).

12. Échangeur de chaleur selon la revendication 10 ou 11,
**caractérisé en ce que**,
- le corps solide (23) est électriquement isolant, ou
- le corps solide (23) est muni d'une couche isolante électriquement isolante pour une isolation électrique par rapport à au moins un tel élément de liaison (9).

13. Échangeur de chaleur selon la revendication 6 et la revendication 11 ou 12,
**caractérisé en ce que**,
la surface, détournée du corps solide (23), d'un tel élément de liaison (9) reposant à plat sur le corps solide est séparée thermiquement de l'espace de circulation (3) grâce à au moins un tel élément de séparation (11).

14. Échangeur de chaleur selon l'une quelconque des revendications 10 à 13,
**caractérisé en ce que**,
- le corps solide (23) est réalisé plein, ou
- le corps solide (23) est conçu comme un corps creux (24) pouvant être parcouru par le fluide de régulation de température.

15. Échangeur de chaleur selon l'une quelconque des revendications 4 à 14,
**caractérisé en ce que**,
au moins un tel élément de liaison (9) est conçu pour être élastique afin de compenser les contraintes thermiques.
